# EUROPÄISCHE PATENTANMELDUNG

(11) **EP 1 176 717 A1**
(43) Veröffentlichungstag der Anmeldung: **30.01.2002**
(21) Anmeldenummer: 00116466.4
(22) Anmeldetag: 29.07.2000
(51) Int. Cl.: H03H 17/02

(54) **Programmierbare Filterachitektur**

(71) Anmelder: Micronas GmbH, 79108 Freiburg (DE)
(72) Erfinder: Temerinac, Miodrag, Prof. Dr.-Ing., 79194 Gundelfingen (DE)
(74) Vertreter: Sauer, Wolfgang, Dipl.-Ing.

(57) **Zusammenfassung**

Filter (50) mit modular zusammengeschalteten Grundeinheiten (10) und einer mit Abgriffen versehenen Verzögerungskette (51) zur Bereitstellung von verzögerten Abtastwerten (x1, ..., xN) eines digitalen Signals (x). Jede Grundeinheit (10) enthält eine programmierbare Gewichtungseinrichtung (11, 12), eine Verknüpfungseinrichtung (13, 14) und eine Verzögerungseinrichtung (15), welche die ihr zugeführte Daten um eine einzige Periode (T) des Abtasttaktes oder ein einfaches ganzzahliges Vielfaches davon zu verzögert. Das Filter (50) enthält ferner eine programmierbare Steuereinrichtung (52), die einen Teil der Dateneingänge (16, 17) der Grundeinheiten (10) zur Erzielung einer Vorwärts- oder Rückwärtsfilterung und/oder einer Vorzeicheninvertierung und/oder einer Änderung der aktiven Filterlänge um- oder abschaltet.

## Beschreibung

Die Erfindung betrifft ein monolitisch integrierbares Filter zur Verarbeitung digitalisierter Signale. Derartige Filter werden in der digitalen Signalverarbeitung für die verschiedensten Aufgaben der Signaltrennung und Signalformung verwendet. Ihre bekannten Vorteile gegenüber analogen Filtern sind einmal die exakte Vorgaben ihrer Eigenschaften und dann ihre Unempfindlichkeit gegenüber Herstellungstoleranzen, Alterung, Temperatureinflüssen, Störungen und anderen Einflüssen. Die Zusammenfassung von immer mehr Funktionseinheiten innerhalb einer einzigen monolitisch integrierten Schaltung führt dazu, daß auch die Anzahl der dabei verwendeten digitalen Filter entsprechend erhöht wird. Wenn die zu verarbeitenden digitalen Signal eine niedere Taktrate aufweisen, dann kann für die digitalen Filter in vielen Fällen ein digitaler Signalprozessor verwendet werden, dessen Programmierung die gewünschte Filterfunktion ergibt. Derartige Filterrealisierungen sind insbesondere dort von Vorteil, wo gegebenenfalls eine Anpassung der Filtereigenschaften an vorgegebene Signalstandards erforderlich ist, beispielsweise bei einem Multi-Standardempfänger für Fernseh- oder Audiosignale. Die Anpassung an die verschiedenen Standards ist bei der Realisierung mittels eines programmierbaren Signalprozessors durch eine entsprechende Anpassung des Programms leicht möglich. Ohne eine derartige Programmierung wäre für unterschiedliche Standards j eweils ein eigener Filtersatz erforderlich. Durch unterschiedliche Programme ist es aber auch möglich, zwischen grundsätzlich unterschiedlichen Filterfunktionen hin und her zu schalten, beispielsweise zwischen einem Tiefpaß- und einem Hochpaßverhalten.

Die Flexibilität eines digitalen Signalprozessors versagt jedoch dort, wo die zu verarbeitenden Datenraten für den jeweiligen Signalprozessor zu hoch sind. Beispielsweise reicht bei Frequenzen über 5 MHz die Geschwindigkeit der heute üblichen Prozessoren in der Regel nicht mehr aus, so daß parallele Hardware-Architekturen für die Filterrealisierung eingesetzt werden müssen, die in monolitisch integrierten Schaltungen flächenaufwendig sind. Die gewünschte Flexibilität muß daher teuer durch die Bereitstellung von parallelen Strukturen erkauft werden, von denen jeweils nur eine einzige in Betrieb ist.

Aufgabe der Erfindung ist es, für die Verarbeitung von digitalen Signalen mit einer hohen Datenrate eine bessere Lösung für ein flexibles Filter anzugeben, das auch monolitisch integrierbar ist.

Die Lösung der Aufgabe erfolgt durch eine Filteranordnung gemäß Anspruch 1. Das Filter weist dabei eine programmierbare Filterarchitektur auf, die im wesentlichen aus modular zusammengeschalteten Grundeinheiten, einer Verzögerungskette und einer programmierbaren Steuereinrichtung besteht. Mittels der Verzögerungskette werden aus einem zugeführten digitalen Signal die erforderlichen Abtastwerte gebildet, die den zusammengeschaltenen Grundeinheiten zugeführt sind. Die einzelnen Abtastwerte repräsentieren dabei das digitale. Signal, wobei die jeweiligen Abtastzeitpunkte einem zugehörigen Abtast- und Digitalisierungstakt entsprechen. Die Verzögerungszeiten der abgegriffenen Abtastwerte liegen dabei um ganzzahlige, insbesondere geradzahlige, Periodenvielfache des Abtasttaktes auseinander. Zur Berechnung der Filterwerte enthält jede Grundeinheit eine programmierbare Gewichtungseinrichtung, eine logische Verknüpfungseinrichtung und eine Verzögerungseinrichtung, welche Zwischenwerte um eine einzige Periode des Abtasttaktes oder ein ganzzahliges Vielfaches davon verzögert. Das Filter enthält ferner eine programmierbare Steuereinrichtung, mit der die grundsätzliche Filterfünktion beeinflußt werden kann, indem ein Teil der Dateneingänge der Grundeinheiten um- oder abschaltbar ist, um für diese Eingänge eine Vorwärts- oder Rückwärtsfilterung zu realisieren und/oder für diese Eingänge das jeweilige Vorzeichen zu invertieren und/oder die aktive Filterlänge zu ändern. Letzteres dient insbesondere dazu, die Anzahl der Abtastwerte nach den jeweiligen Erfordernissen gerad- oder ungeradzahlig zu machen. Die Programmierbarkeit der Gewichtungseinrichtung wird mittels eines Multiplizierers und eines vorgebbaren Koeffizienten realisiert, der in der jeweiligen Grundeinrichtung in einem Register gespeichert und mittels eines Koeffizientenbusses austauschbar ist. Die programmierbare Steuereinrichtung enthält Schalteinrichtungen, die etwa die Hälfte der Dateneingänge der Grundeinheiten entweder mit dem Ausgang der Verzögerungskette oder mit dem Ausgang der modular zusammengeschalteten Grundeinheiten verkoppelt. Ferner enthält die programmierbare Steuereinrichtung im Signalpfad zu den ebe erwähnten Dateneingängen einen Vorzeicheninverter, der in Abhängigkeit von einem programmbierbaren Steuersignal das Vorzeichen der über ihn geführten Datenwerte invertiert.

Sollte in dem jeweiligen Anwendungsfall einmal nicht sämtliche Programmierungsmöglichkeiten ausgeschöpft werden, dann sind entsprechende Vereinfachungen selbstverständlich ohne weiteres möglich. Es kann sich ferner auch als zweckmäßig erweisen, daß nur eine oder zwei Stufen am Anfang oder Ende der modular zusammengeschalteten Grundeinheiten modifiziert sind.

Die programmierbare Architektur ist dazu geeignet, linearphasige FIR-Filter (FIR = Finite Impulse Response) mit einer "gerade-symmetrischen" oder "ungerade-symmetrischen" Impulsantwort und IIR-Allpassfilter (IIR = Infinite Impulse Response) mit ungerader Filterlänge für Tiefpässe, Hochpässe oder Gruppenlaufzeitfilter zu realisieren. Gerade die linearphasigen Filter finden in der digitalen Signalverarbeitung wichtige Anwendungen, beispielsweise als Hilbert-Filterpaar zur Trennung von quadraturmodulierten Signalen. Die Erfindung und vorteilhafte Weiterbildungen werden nun anhand der Figuren der Zeichnung näher erläutert:
Figur 1 zeigt schematisch eine Grundeinheit,
Figur 2 zeigt schematisch eine modifizierte Grundeinheit,
Figur 3 zeigt schematisch ein modifiziertes Modul in einem IIR-Filter,
Figur 4 zeigt schematisch die Architektur eines programmierbaren Filters,
Figur 5 bis Figur 8 zeigen unterschiedliche Impulsantworten,
Figur 9 zeigt eine erste Anwendung der Erfindung in einer Allpassanordnung und
Figur 10 zeigt eine zweite Anwendung der Erfindung bei einem Nyquist-Filterpaar.

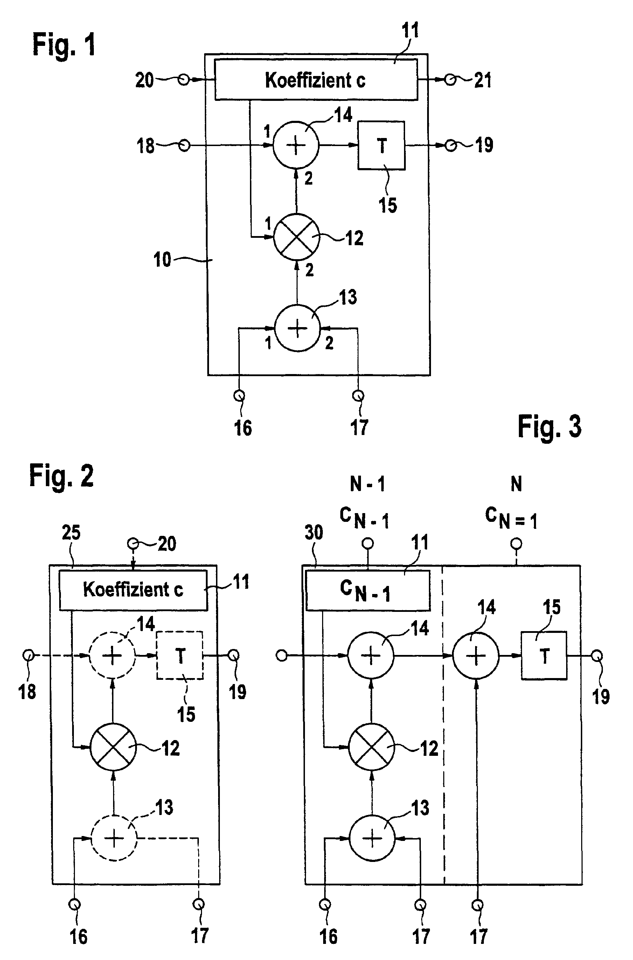

Figur 1 zeigt schematisch als Blockschaltbild eine Grundeinheit 10, die als modulare Einheit innerhalb der gesamten Filterarchitektur dient. Jede Grundeinheit 10 enthält dabei diejenigen Funktionseinheiten, die für die Berechnung der modularen Filterwerte erforderlich sind. Dies ist einmal eine programmierbare Gewichtseinrichtung 11, 12 mit einem Register 11 und einem Multiplizierer 12, eine Verknüpfüngseinrichtung 13, 14 mit einem ersten und zweiten Addierer 13 bzw. 14 und schließlich eine Verzögerungseinrichtung 15, zur Verzögerung der resultierenden Daten um eine Periode T des Abtasttaktes. Über die Programmierung eines Koeffizienten c, der im Register 11 gespeichert ist, wird die Gewichtung gesteuert. Dabei liegt der Koeffizient c an einem ersten Eingang 1 des Multiplizierers 12 und die zu gewichteten Daten an einem zweiten Eingang 2. Jede Grundeinheit 10 weist drei Dateneingänge 16, 17, 18 auf, wobei der erste und zweite Dateneingang 16, 17 der Zuführung der mit dem gleichen Koeffizient c zu gewichteten Daten dient, die im ersten Addierer 13 addiert werden und dem zweiten Eingang 2 des Multiplizierers 12 zugerührt sind.

Der Ausgangsdatenwert des Nachbarmoduls ist über den dritten Dateneingang 18 zugeführt und mittels des zweiten Addierers 14 mit den gewichteten Daten am Ausgang des Multiplizierers 12 kombiniert. Der Ausgangsdatenwert des zweiten Addierers 14 wird mittels der Verzögerungseinrichtung 15 um eine Periode T des Abtasttaktes verzögert und danach einem Datenausgang 19 der Grundeinheit 10 zugeführt. Benachbarte Grundeinheiten 10 sind in Signalflußrichtung über ihre Datenausgänge 19 und Dateneingänge 18 miteinander verbunden.

Damit der Koeffizient c im Register 11 ausgetauscht werden kann, enthält das Register einen Koeffizienteneingang 20. Zweckmäßigerweise ist auch ein Koeffizientenausgang 21 vorhanden, um alle Register 11 der modular zusammengeschalteten Grundeinheiten 10 in der Art eines Schieberegisters zusammenzuschalten. Mittels dieses Schieberegisters können dann sämtliche Koeffizienten cᵢ von einem Steuerprozessor 60, vgl. Figur 3, leicht ausgetauscht werden. Müssen die Koeffizienten c; nicht geändert werden, dann erübrigt sich der jeweilige Koeffizienteneingang und der Koeffizient c ist im Register 11 fest gespeichert.

In Figur 2 wird schematisch als Blockschaltbild eine modifizierte Grundeinheit 25 gezeigt, in der die gestrichelten Funktionseinheiten optional sind und gegebenenfalls fehlen können. Beispielsweise ist bei der ersten Stufe der modular zusammengeschalteten Grundeinheiten nie ein dritter Dateneingang 18 und ein zugehöriger zweiter Addierer 14 erforderlich. Der Ausgangswert des Multiplizierers 12 kann somit direkt auf den Eingang der Verzögerungseinrichtung 15 geführt werden. Bei einer unveränderten Grundeinheit 10 würde in diesem Fall dem dritten Dateneingang 18 und damit dem Addierer 14 der Wert Null zugeführt werden.

Bei der letzten Stufe N der modular zusammengeschalteten Grundeinheiten 10 kann gegebenenfalls der zweite Dateneingang 17 und der zugehörige erster Addierer 13 fehlen, wenn die Anzahl der erforderlichen Abtastwerte stets ungeradzahlig ist.

In einigen Fällen fehlt bei rückgekoppelten Filtern in der letzten oder vorletzten Stufe auch die Verzögerungseinrichtung 15. Ein spezielles Ausführungsbeispiel der beiden letzten Stufen derartiger rückgekoppelter Filter zeigt Figur 3.

Figur 3 zeigt schematisch das Blockschaltbild eines Moduls 30, das beispielsweise bei einem IIR-Filter den beiden letzten Stufen N-1 und N der modular zusammengeschalteten Grundeinheiten 10 entspricht. Hierbei erfolgt nur noch in der Stufe N-1 eine Gewichtung mit dem Gewichtungsfaktor c_{N-1}. Der Gewichtungsfaktor in der letzten Stufe N entspricht dem festen Wert Eins, was einer unveränderten Durchreichung des Datenwertes entspricht. Es fehlt ferner im Modul 30 gegenüber den vollständigen Grundeinheiten 10 eine der beiden Verzögerungsstufen 15 und der zweite Dateneingang 17 der letzten Stufe N.

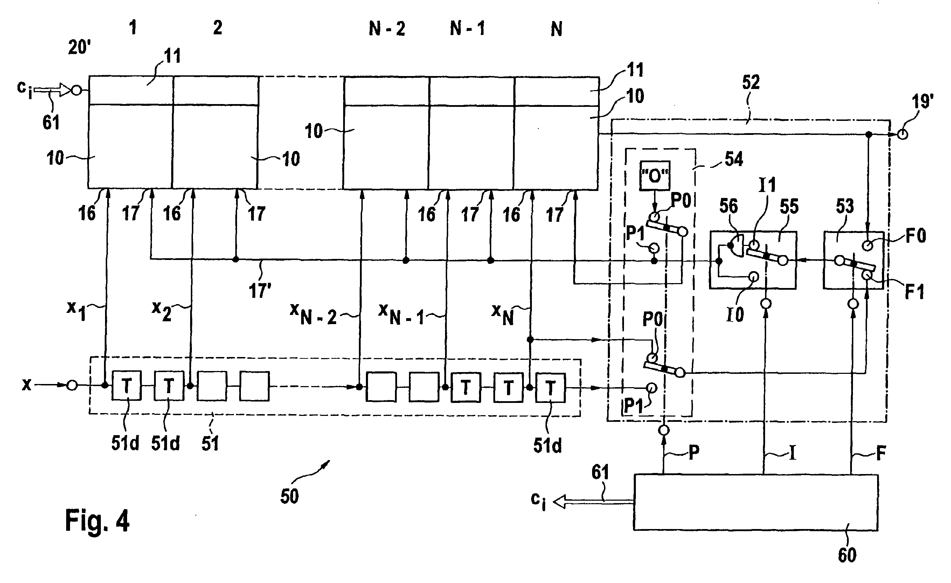

Figur 4 zeigt schematisch als Blockschaltbild die Architektur eines programmierbaren Filters 50, das als Filterrecheneinheit N modular zusammengeschalteten Grundeinheiten 10 enthält. Die ersten Dateneingänge 16 sind dabei mit den Abgriffen einer Verzögerungskette 51 verbunden, die N verzögerte Abtastwerten x₁ bis x_{N} an ihren Abgriffen zur Verfügung stellt. Dem Eingang der Verzögerungskette 51 ist ein digitales Signal x zugeführt, das mittels des Filters 50 zu verarbeiten ist und an einem Ausgang 19' als gefiltertes Ausgangssignal xf für die weitere Verarbeitung zur Verfügung steht. Die Verzögerungskette 51 besteht aus einer Reihenschaltung von Verzögerungsstufen 51d, die jeweils das digitale Signal um die Periode T des zugehörigen Digitalisierungstaktes verzögern. In dem Ausführungsbeispiel nach Fig. 4 wird nicht hinter jeder Verzögerungsstufe ein Abtastwert abgegriffen, sondern jeweils erst nach zwei Verzögerungsstufen 51d. Sämtliche Abtastwerte x₁ bis x_{N} sind bezüglich des digitalen Signals x äquidistant und stehen parallel zur Verarbeitung in den Grundeinheiten 10 zur Verfügung.

Wie bereits erwähnt werden in den Grundeinheiten 10 folgende Operationen durchgerührt: Additionen, Multiplikationen von Zwischenwerten mit einem festen Koeffizienten cᵢ und eine Verzögerung um ganzzahlige Perioden T des Digitalisierungstaktes, insbesondere um einen einzigen Takt. Zur Grundsätzlichen Änderung der Filterfunktion des programmierbaren Filters 50, ist jedoch eine programmierbare Steuereinrichtung 52 erforderlich. Diese enthält eine erste Schalteinrichtung 53, die mit den zweiten Dateneingängen 17 der modular zusammengeschalteten Grundeinheiten 10 verkoppelt ist und die zugehörigen Datenquellen wahlweise steuern kann. Ferner eine zweite Schalteinrichtung 54, mit der die Anzahl der verzögerten Abtastwerte xₗ bis x_{N} verändert werden kann, um wahlweise eine geradzahlige oder ungeradzahlige Anzahl von Abtastwerten zur Verfügung zu haben. Und schließlich enthält die programmierbare Steuereinrichtung 52 noch einen schaltbaren Vorzeicheninverter 55, mit dem wahlweise eine Invertierung der den zweiten Dateneingängen 17 zugeführten Datenwerte möglich ist. In dem Ausführungsbeispiel des Filters 50 von Fig. 4 enthält die programmierbare Steuereinrichtung 52 in den einzelnen Schalteinrichtungen 53, 54, 55 elektronische Umschalter, die von Steuersignalen F, P, I aus einem Steuerprozessor 60 gesteuert sind. Die elektronischen Umschalter dienen vorwiegend der Erläuterung der Schaltungsfunktion. Bei der monolitischen Integration sind sie selbstverständlich durch rein elektronische Schaltmittel ersetzt oder innerhalb der jeweiligen Funktionseinheit auf andere Weise realisiert.

Die erste Schalteinrichtung 53 enthält in der Darstellung von Fig. 4 einen elektronischen Umschalter, der eine erste und zweite Schaltposition F1 bzw. F0 annehmen kann. In der ersten Schaltposition F1 ist der Ausgang des elektronischen Umschalters mit dem Ausgang der Verzögerungskette 51 verkoppelt und in der zweiten Schaltposition F0 mit dem letzten Datenausgang 19' der modular zusammengeschalteten Grundeineinheiten 10 und speist dadurch die zweiten Dateneingänge 17 mit dem gefilterten Ausgangssignal xf oder einem von ihm abgeleiteten Datenwert. Die Steuerung der ersten Schalteinrichtung 53 erfolgt über ein erstes Steuersignal F aus dem Steuerprozessors 60, der entweder mitintegriert oder als externe Steuereinrichtung vorhanden ist.

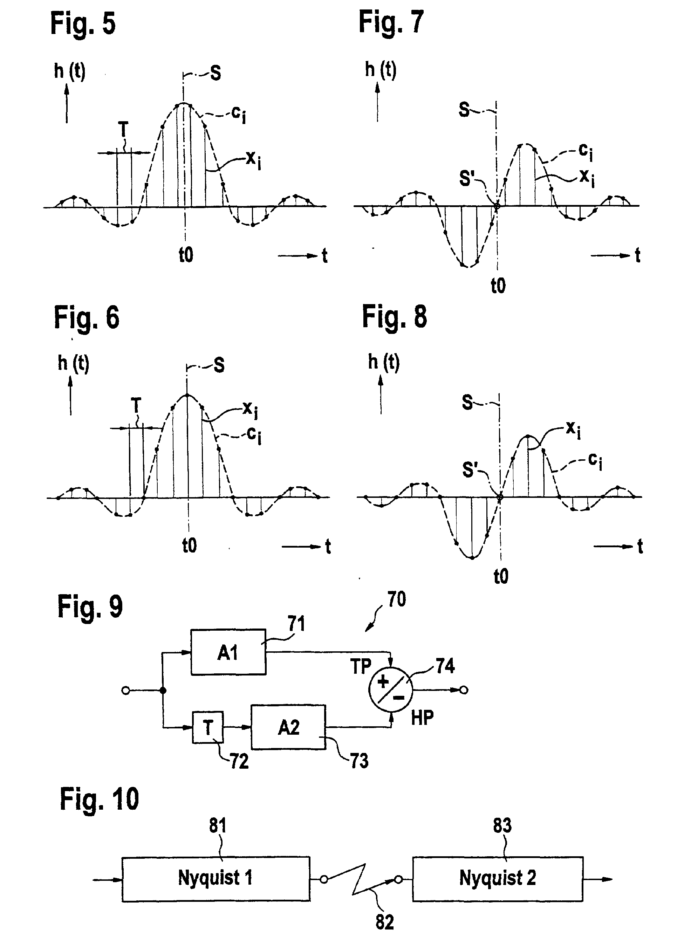

Die zweite Schalteinrichtung 54 in der Darstellung von Fig. 5 enthält zwei gekoppelte elektronische Umschalter mit einer ersten und zweiten Schaltposition P1 bzw. P0. Der erste Umschalter der Schalteinrichtung 54 ist mit der letzten Stufe N der Verzögerungskette 51 gekoppelt. In der ersten Schaltposition P1 wird als Ausgangssignal der Verzögerungskette -das Signal nach der letzten Verzögerungsstufe abgegriffen. In der zweiten Schaltposition P0 wird das Signal X_{N} vor dieser letzten Verzögerungsstufe abgegriffen, das auch dem ersten Dateneingang 16 der letzten Grundeinheit N zugeführt ist. Diese Umschaltung ermöglichst es Filter mit einer geradzahligen oder ungeradzahligen Anzahl von Abtastwerten zu realisieren. Dies hängt von der Anzahl der wirksamen Verzögerungsstufen 51d ab; entweder ist deren Anzahl gerade oder ungerade. Der zweite Umschalter der Schalteinrichtung 54 ist mit der letzten Stufe N der modular zusammengeschalteten Grundeinheiten 10 gekoppelt. Der Ausgang dieses Umschalters verbindet in der ersten Schaltposition P1 den zweiten Dateneingang 17 mit der Datenleitung 17' für die anderen zweiten Dateneingängen 17. In der zweiten Schaltposition P0 wird der zweite Dateneingang 17 der letzten Stufe N der modular zusammengeschalteten Grundeinheiten 10 unwirksam geschaltet, d.h. entweder gesperrt oder mit dem neutralen Datenwert Null gespeist. Die Steuerung der zweiten Schalteinrichtung 54 erfolgt durch ein zweites Steuersignal P, das aus dem externen oder mitintegrierten Steuerprozessor 60 stammt.

Der Vorzeicheninverter 55 ist in Fig. 4 der Verdeutlichung der Funktionsweise ebenfalls mit einem elektrischen Umschalter dargestellt, dessen beide Schaltpositionen I1, I0 von einem dritten Steuersignal I aus dem Steuerprozessor 60 abhängig sind. In der Schaltposition I0 wird der zugeführte Datenwert unverändert, allenfalls durch einen Laufzeitausgleich verzögert, durch den Vorzeicheninverter 55 hindurchgeschaltet. In der Schaltposition I1 wird der zugeführte Datenwert über eine Invertierungseinrichtung 56 geführt und damit im Vorzeichen geändert. Da für die digitale Signalverarbeitung und damit auch für die Filterrechenvorgänge im allgemeinen das Zweierkomplement-Zahlensystem zwischen den Werten -1 und +1 verwendet wird, ist die Invertierungseinrichtung 56 entsprechend angepaßt. Falls die Invertierung eine zusätzliche Verzögerungszeit für die zu invertierenden Daten mit sich bringt, muß dies durch einen Laufzeitausgleich an den relevanten Stellen in der Filterarchitektur berücksichtigt werden.

Der Eingang des Vorzeicheninverters 55 ist mit dem Ausgang der ersten Schalteinrichtung 53 verbunden. Der Ausgang des Vorzeicheninverters 55 speist die gemeinsamen Datenleitung 17' für die zweiten Dateneingänge 17 der modular zusammengeschalteten Grundeinheiten 10. In Abhängigkeit vom dritten Steuersignal I können dadurch sämtliche zweiten Dateneingänge 17 mit dem invertierten oder nicht invertierten Datenwert gespeist werden. Ob dieser Datenwert am Ende der Verzögerungskette 51 oder am Ende der modular zusammengeschalteten Grundeinheiten 10 abgegriffen wird, hängt wie bereits erwähnt von der Schaltposition F1, F0 der ersten Schalteinrichtung 53 ab.

Die Koeffizienten cᵢ zur Steuerung der Gewichtungseinrichtungen 11, 12 in den Grundeinheiten 10 werden ebenfalls vom Steuerprozessor 60 erzeugt, bzw. aus einer mit ihm verkoppelten Speichereinrichtung abgerufen. Über einen Koeffizientenbus 61 werden diese Koeffizienten cᵢ in die Register 11 der modular zusammengeschalteten Grundeinheiten 10 geladen. Dies kann über einen Parallelbus erfolgen, der jedes Register 11 über einen separaten Koeffizienteneingang 20 ansteuert. Wenn das Filter 50 beispielsweise 20 modular zusammengeschaltete Grundeinheiten 10 enthält, dann ist ein paralleler Koeffizientbus 61 sehr flächenaufwendig. Zweckmäßiger ist daher ein serieller Koeffizientenbus wie er in Fig. 4 dargestellt ist. Alle Register 11 sind dabei wie bei einem Schieberegister in Serie geschaltet und die Koeffizienten cᵢ werden seriell am Koeffizienteneingang 20' seriell in die einzelnen Register 11 eingelesen.

Die Figuren Fig. 5 bis Fig. 8 zeigen typische Impulsantworten h(t) von FIR-Filtern, die mit dem programmierbaren Filter 50 realisiert werden können. Ob die Filterlänge dabei gerade wie in Fig. 5 und Fig. 7 oder ungerade wie in Fig. 6 und Fig. 8 ist, hängt von der Schaltposition der zweiten Schalteinrichtung 54 (vergl. Fig. 3) ab. Bei allen Figuren 5 bis 8 sind die für die Berechnung des Ausgangssignals xf erforderlichen Abtastwerte xi äquidistant im Abstand der Taktperiode T angeordnet. Sie liegen symmetrisch rechts und links zum Bezugszeitpunkt t0. Bei einer garaden Anzahl von Abtastwerten xi wie in Fig. 5 und Fig. 7 gibt es zum Bezugszeitpunkt t0 keinen zentralen Abtastwert sondern nur zu den benachbarten Zeitpunkten +/- T/2. Die weiteren Abtastwerte folgen dann rechts und links im Abstand von +/- T. Bei einer ungeraden Anzahl von Abtastwerten xi wie in Fig. 6 und Fig. 8 liegt der zentrale Abtastwert genau beim Bezugszeitpunkt t0 und im Abstand von +/- T folgen dann die nächsten Abtastwerte rechts und links davon.

Bevorzugte Impulsantworten h(t) weisen dabei eine Symmetrie auf. Bei Fig. 5 und Fig. 6 ist der Impulsverlauf "gerade-symmetrisch" und bei Fig. 7 und Fig. 8 "ungerade-symmetrisch". Die Bezeichung "gerade-symmetrisch" entspricht dabei mathematisch einer Achsensymmetrie, die in den Figuren 5 und 6 durch eine durch den Bezugszeitpunkt t0 laufende Symmetrieachse S definiert ist. Die Bezeichnung "ungerade-symmetrisch" entspricht dabei mathematisch einer Punktsymmetrie, die in den Figuren 7 und 8 durch einen Symmetriepunkt S' definiert ist, der beim Bezugszeitpunkt t0 auf der Zeitachse t liegt und durch den auch die Impulsantwort h(t) geht. Im programmierbaren Filter 50 wird die ungerade Symmetrie entsprechend den Figuren 7 und 8 durch den Vorzeicheninverter 55 erreicht, der gleichsam die links vom Bezugszeitpunkt t0 stehenden Filterausgangswerte einer an der Symmetrieachse S gespiegelten gerade-symmetrischen Impulsanwort invertiert.

Durch geeignete Wahl der Koeffizienten cᵢ wird der jeweilige Verlauf der Impulsantwort programmiert. In den Figuren 5 bis 8 wird die betragsmäßige Symmetrie der Impulsanwort h(t) rechts und links zum Bezugszeitpunkt t0 durch die spezielle Speisung der ersten und zweiten Dateneingänge 16, 17 und die Zuordung zu dem jeweiligen Koeffizienten c realisiert, der für den ersten und zweiten Dateneingang 16, 17 jeder Grundeinheit 10 identisch ist. Der Beitrag jedes Abtastwertes xᵢ zur Impulsanwort h(t) ist in Fig. 5 bis Fig. 8 durch den zugehörigen positiven oder negativen Wert der der gestrichelte Kurve ci dargestellt. Dieser Wert ci entspricht somit direkt dem für diesen Abtastwert xi gültigen Koeffizienten ci.

Die folgende Aufstellung zeigt einige vorteilhafte Anwendungen des programmierbaren Filters 50 in der digitalen Signalverarbeitung, insbesondere in monolithisch integrierten Schaltungen zur Verarbeitung von Signalen der Unterhaltungstechnik. Auf die Größe der jeweiligen Koeffizienten ci und die Filterlänge soll hierbei nicht näher eingegangen werden da dies von der jeweiligen Anforderung und Signalform abhängig ist und andererseits nach üblichen Verfahren, Berechung oder Simulation ohnehin auch bei festen Filtern zu ermitteln ist. Es ist daher ausreichend, wenn für die beispielhaften Anwendungen lediglich die Schaltpositionen der programmierbaren Steuereinrichtung 52 angegeben werden.

Eine wichtige Anwendungsgruppe betrifft die Realisierung von IIR-Allpässen für Tief- oder Hochpassfilter oder Gruppenlaufzeitentzerrer, die auch als Equilizer bezeichnet werden. Da es sich um Rückkopplungsschaltungen handelt, ist für die erste Schalteinrichtung 53 die Schaltposition F0 einzustellen. Die Filterlänge ist immer ungerade, so daß für die zweite Schalteinrichtung 54 die Schaltposition P0 programmiert wird. Schließlich wird der Vorzeicheninverter 55 in die Schaltposition I1 gebracht, in der die Vorzeichen der rückgeführten Datenwerte invertiert werden. Auf der Abtastfrequenz 1/T darf die vorletzte Grundeinheit N-1 in der Gewichtungseinrichtung 11, 12 und in dem Signalpfad zum Datenausgang 19 keinerlei Verzögerung aufweisen. Die die Verzögerungseinrichtung 15 muß somit entfallen . Der betroffene Multiplizierer 12 darf daher auch keine Verzögerung aufweisen. Er muß so schnell wie möglich sein und muß alle erforderlichen Schritte für die Multiplikation, wie Bildung der Partialprodukte und deren Addition, ohne Zeitverlust im Parallelbetrieb ausführen. Die Gewichtung in der letzten Grundeinheit hat den Wert c_{N} = 1 und erfordert keinen Multiplizierer 12. Der Datenwert kann anstatt über einen schnellen Multiplizierer geführt zu werden einfach durchgeleitet werden, damit tritt hier kein Verzögerungsproblem auf. Die beiden letzen Grundeinheiten N und N-1 werden daher zweckmäßigerweise als ein spezielles Modul entsprechend Fig. 3 zusammengefaßt, das in der IIR-Anwendung die beiden letzten Grundeinheiten 10 ersetzt.

Die andere wichtige Gruppe stellt die Realisierung von linearphasigen FIR-Filtern dar, die beispielsweise beim Empfang von digital übertragenen Daten auf der Sender- und Empfängerseite als Nyquistfilter zur Vermeidung von Intersymbolinterferenzen dienen. Derartige Filter sind in der angelsächsischen Literatur auch unter dem Namen "Raised Cosine Filter" bekannt. Derartige Filter sind ohne Signalrückführung und haben eine "geradesymmetrische" Impulsantwort h(t) und weisen meist eine gerade Filterlänge auf. Eine Invertierung von Daten findet nicht statt. Die programmierbare Steuereinrichtung 52 muß somit die Schaltpositionen F1, Plund I0 vorgeben. Relativ selten ist bei FIR-Filtern die Filterlänge ungerade, was dann die Schaltposition P0 der zweiten Schalteinrichtung 54 erfordert.

Zu den FIR-Filtern gehören auch die Hilpert-Filter, die auch als Hilpert-Filterpaar auftreten können. Die Filterlänge ist meist gerade, so daß die zweite Schalteinrichtung 54 in der Regel in die Schaltposition P1 zu bringen ist. Der Verlauf der Impulsantwort h(t) kann sowohl gerade-symmetrisch als auch ungerade-symmetrisch sein. Beim gerade-symmetrischen Verlauf entspricht die Einstellung der Schaltpositionen dem bereits erwähnten Nyquist-Filter mit F1, P1 und I0. Die erste Schalteinrichtung 53 befindet sich selbstverständlich in der Schaltposition F1.

Beim ungerade-symmetrischen Verlauf der Impulsantwort h(t) ist die Filterlänge meist gerade, so daß die zweite Schalteinrichtung 54 in der Regel in die Schaltposition P1 zu bringen ist. Der ungerade-symmetrische Verlauf erfordert die Invertierung der über den Vorzeicheninverter 55 geführten Daten. Die zugehörige Schaltposition ist daher I1. Auch hier befindet sich die erste Schalteinrichtung 53 selbstverständlich in der Schaltposition F1.

Bei der Bearbeitung von quadraturmodulierten Signalen werden gelegentlich auch Hilpert-Filterpaare verwendet, deren Impulsantworten h(t) miteinander in Beziehung stehen, wobei das eine Hilpert-Filter eine gerade- und das andere Hilpert-Filter eine ungerade-symmetrische Impulsantwort h(t) aufweist.

Fig. 9 zeigt eine IIR-Allpassanwendung 70, die zwei unterschiedliche Allpässe 71, 73, eine Verzögerungsstufe 72 und einen Addierer/Subtrahierer 74 erfordert. Jeder der beiden Allpässe 71, 73 kann mit dem programmierbaren Filter 50 nach Fig. 4 realsiert werden. Werden die Daten beider Signalzweige in dem Addierer/Subtrahierer 74 addiert, dann hat die Schaltung 70 die Funktion eines Tiefpasses. Bei eine Subtraktion beider Signalzweige, hat die Schaltung 70 die Funktion eines Hochpasses. Die Lage der Selektionsflanke wird duch die Vorgabe der Koeffizienten ci bestimmt.

Fig .10 zeigt schließlich schematisch ein Anwendungsbeispiel für zwei FIR-Filter 81, 83, die als senderseitiges und empfängerseitiges Nyquistfilter 1 bzw. 2 bei der Übertragung von Daten dienen. Mit ihnen soll die Intersymbolinterferenz beim Empfang benachbarter Daten verhindert werden, wobei die erforderliche Bandbreite möglichst klein sein soll. Dies ermöglicht auch bei gestörten Übertragungswegen 82 einen sicheren Empfang der Daten. Derartige Nyquistfilter sind relativ aufwendig und je mehr unterschiedliche Datenquellen und entsprechende Übertragungsstandards zur Verfügung stehen und erfaßt werden sollen, desto vorteilhafter erweist sich die Anpassung an die einzelnen Übertragungsstandards über die Progammierbarkeit der zugehörigen Nyquistfilter.

## Patentansprüche

1. Filter (50) mit modular zusammengeschalteten Grundeinheiten (10) und einer mit Abgriffen versehenen Verzögerungskette (51) zur Bereitstellung von verzögerten Abtastwerten (x1, ..., xN; xi) eines digitalen Signals (x), wobei die Verzögerungszeiten der Abtastwerte ganzzahlige, insbesondere geradzahlige, Periodenvielfache n mit n=0, 1, 2, 3, ... eines mit dem digitalen Signal (x) verkoppelten Abtasttaktes sind,
- jede Grundeinheit (10) enthält eine programmierbare Gewichtungseinrichtung (11, 12), eine Verknüpfungseinrichtung (13, 14) und eine Verzögerungseinrichtung (15), welche die ihr zugeführte Daten um eine einzige Periode (T) des Abtasttaktes oder ein einfaches ganzzahliges Vielfaches davon zu verzögert, und
- das Filter (50) enthält ferner eine programmierbare Steuereinrichtung (52), die einen Teil, insbesondere die Hälfte, der Dateneingänge (16, 17) der Grundeinheiten (10) zur Erzielung einer Vorwärts- und/oder Rückwärtsfilterung und/oder einer Vorzeicheninvertierung und/oder einer Änderung der aktiven Filterlänge um- oder abschaltet.

2. Filter (50) nach Anspruch 1, **dadurch gekennzeichnet, daß** die programmierbare Steuereinrichtung (52) eine erste Schalteinrichtung (53) enthält, die in Abhängigkeit von einem ersten Steuersignal (F), einen Teil, insbesondere die Hälfte, der Dateneingänge (16, 17) der modular zusammengeschalteten Grundeinheiten (10) entweder an die Verzögerungskette (51) oder an die modular zusammengeschalteten Grundeinheiten (10) koppelt.

3. Filter (50) nach Anspruch 1 oder 2, **dadurch gekennzeichnet, daß** die programmierbare Steuereinrichtung (52) eine zweite Schalteinrichtung (54) enthält, die in Abhängigkeit von einem zweiten Steuersignal (P) eine, insbesondere eine letzte Stufe (N) der Verzögerungskette (51) und/oder einen Dateneingang (17), insbesondere den der letzten Stufe (N). der modular zusammengeschalteten Grundeinheiten (10) unwirksam schaltet.

4. Filter (50) nach einem der Ansprüche 1 bis 3, **dadurch gekennzeichnet, daß** die programmierbare Steuereinrichtung (52) einen Vorzeicheninverter (55) enthält, der in Abhängigkeit von einem dritten Steuersignal (I) die Vorzeichen der über ihn geführten Datenwerte, die den zugehörigen Dateneingängen (17) der modular zusammengeschalteten Grundeinheiten (10) zugeführt sind, invertiert.

5. Filter (50) nach einem der Ansprüche 1 bis 4, **dadurch gekennzeichnet, daß** die programmierbare Gewichtungseinrichtung (11, 12) einen Multiplizierer (12) enthält, dessen erstem Eingang (1) ein Koeffizient (c) und dessen zweitem Eingang (2) ein zu gewichtender Datenwert zugeführt sind, wobei der Koeffizient (c) programmierbar und in einem Register (11) gespeichert ist.

6. Filter (50) nach einem der Ansprüche 1 bis 5, **dadurch gekennzeichnet daß** die Verknüpfungseinrichtung (13, 14) einen ersten Addierer (13) enthält, dessen erster bzw. zweiter Eingang (1, 2) mit einem ersten bzw. zweiten Dateneingang (16, 17) der Grundeinheit (10) und dessen Ausgang mit dem zweiten Eingang (2) des Multiplizierers (12) gekoppelt ist.

7. Filter (50) nach Anspruch 6, **dadurch gekennzeichnet, daß** die jeweiligen ersten Dateneingänge (16) der modular zusammengeschalteten Grundeinheiten (10) mit den verzögerten Abtastwerten (x1, ..., xN) in zeitlich aufeinanderfolgender Ordnung gespeist sind und die jeweiligen zweiten Dateneingänge (17) im wesentlichen einheitlich mit einem einzigen Datenwert, der in einer ersten Schaltposition (F1) der ersten Schalteinrichtung (53) mit der Verzögerungskette (51) und in einer zweiten Schaltposition (F0) mit mindestens einem Datenausgang (19') der modular zusammengeschalteten Grundeinheiten (10) verkoppelt ist.

8. Filter (50) nach Anspruch 6 oder 7, **dadurch gekennzeichnet, daß** die Verknüpfungseinrichtung (13, 14) einen zweiten Addierer (14) enthält, dessen erster bzw. zweiter Eingang (1, 2) mit einem dritten Dateneingang (18) der Grundeinheit (10) bzw. mit dem Ausgang des Multiplizierers (12) und dessen Ausgang mit dem Eingang der Verzögerungseinrichtung (15) gekoppelt ist, wobei der dritte Dateneingang (18) der Übernahme eines Ausgangsdatenwertes der vorausgehenden Grundeinheit (10) dient und der Ausgang der Verzögerungseinrichtung (15) mit einem Datenausgang (19) der Grundeinheit (10) verbunden ist.

9. Filter (50) nach einem der Ansprüche 1 bis 8, **dadurch gekennzeichnet, daß** die Register (11) der modular zusammengeschalteten Grundeinheiten (10) über einen Koeffizienteneingang (20, 20') und einen Koeffizientenausgang (21) wie ein Schieberegister miteinander verknüpft sind, um die Koeffizienten (c) seriell in die Register zu schreiben.

10. Filter (50) nach einem der Ansprüche 1 bis 9, **dadurch gekennzeichnet, daß** die Anzahl der vorhandenen Funktionseinheiten in den Grundeinheiten (10), insbesondere am Anfang und/oder Ende der modular zusammengeschalteten Grundeinheiten (10), reduziert ist, wodurch modifizierte Grundeinheiten (25; 30) entstehen.
